# EUROPÄISCHE PATENTANMELDUNG

(11) **EP 4 654 034 A1**
(43) Veröffentlichungstag der Anmeldung: **26.11.2025**
(21) Anmeldenummer: 24177707.7
(22) Anmeldetag: 23.05.2024
(51) Int. Cl.: G06F 13/38, G06F 15/78, G06F 13/40

(54) **ANORDNUNG FÜR EINE ELEKTRONISCHE RECHENEINRICHTUNG, SOWIE VERFAHREN ZUM BETREIBEN EINER ANORDNUNG**

(71) Anmelder: Siemens Aktiengesellschaft, 80333 München (DE)
(72) Erfinder: Barthelmess, Bernd, 90574 Roßtal (DE); Nickl, Felix, 91233 Neunkirchen a. Sand (DE); Witterauf, Michael, 91052 Erlangen (DE)
(74) Vertreter: Siemens Patent Attorneys

(57) **Zusammenfassung**

Die Erfindung betrifft eine Anordnung (16) für eine elektronische Recheneinrichtung(10), mit zumindest einem Mikrocontroller (12) und zumindest einem Eingabe-/Ausgabegerät (18, 20), welches mit dem Mikrokontroller (12) kommuniziert, dadurch gekennzeichnet, dass zwischen dem Mikrocontroller (12) und dem Eingabe-/Ausgabegerät (18, 20) ein integrierter Schaltkreis (14) angeordnet ist, welcher zum Steuern einer Kommunikation zwischen dem Mikrocontroller (12) und dem Eingabe-/Ausgabegerät (18, 20) ausgebildet ist, wobei der integrierte Schaltkreis (14) für eine Erfassung eines Anschluss wenigstens eines Eingabe-/Ausgabegeräts (18, 20) am integrierten Schaltkreis (14), der Identifikation des Eingabe-/Ausgabegeräts (18, 20) und zum Empfang eines Bitstreams für das jeweilige Eingabe-/Ausgabegerät (18, 20) ausgebildet ist, wobei der integrierte Schaltkreis (14) weiter dazu ausgebildet ist, für den Fall, dass für das jeweilige Eingabe-/Ausgabegerät (18, 20) kein Bitstream empfangen wird, eine Erweiterungsbeschreibung zu erzeugen und auf der Speichereinrichtung (22) zu speichern, wobei der integrierte Schaltkreis (14) für ein partielles Rekonfigurieren einer Partition des integrierten Schaltkreises (14) in Abhängigkeit von dem jeweils empfangenen Bitstream ausgebildet ist. Ferner betrifft die Erfindung ein Verfahren zum Betreiben der Anordnung (16).

## Beschreibung

Die Erfindung betrifft eine Anordnung für eine elektronische Recheneinrichtung, mit zumindest einem Mikrocontroller und zumindest einem Eingabe-/Ausgabegerät, welches mit dem Mikrocontroller kommuniziert gemäß dem geltenden Patentanspruch 1. Ferner betrifft die Erfindung ein entsprechendes Verfahren zum Betreiben einer solchen Anordnung.

Systementwickler möchten Gateway-Geräte, insbesondere Geräte, die die Konnektivität von anderen Geräten verbessern, zum Beispiel Sensoren oder Aktoren an einem Netzwerk anbinden, oder auch North- und South-Boundkommunikation trennen oder dgl., möglichst flexibel prototypisieren. Um dies zu erreichen, kann Modularität auf dem PCB-Level angeboten werden. Der Nutzer schließt dabei zusätzliche Schnittstellen-Erweiterungsmodule an vorher definierte Konnektoren an. Hierbei gibt es folgende Probleme. Die Schnittstellen benötigen unterschiedliche Verarbeitung ihrer Daten- und Kontrollsignale, wobei gewisse Timing-Garantien und -Beschränkungen in einer Software schwer umzusetzen sind. Ein Mikrocontroller, der das Gateway-Gerät steuert, bietet in aller Regel nur eine begrenzte, oft geringe, Anzahl an Schnittstellen mit vorgegebenen Typen an. Oft sind diese Schnittstellen schon alle reserviert für andere notwendige Anwendungen, etwa zum Anschließen von Flash-Speichern oder fest eingebauten Ethernet-Controllern. Um die mögliche Konfiguration flexibel zu halten - jedes Erweiterungsmodul kann an jeden Konnektor angeschlossen werden - müsste man von jedem Konnektor zu jeder Schnittstelle des Mikrocontrollers routen können. Oft ist es auch der Fall, dass Erweiterungsmodule Schnittstellen implementieren, die keinerlei Entsprechung am Mikrocontroller haben. Die Erweiterungsmodule sollen automatisch erkannt und konfiguriert werden, um Fehlerquellen und unnötigen Arbeitsaufwand zu vermeiden. Zusammenfassend ist also ein Problem im Stand der Technik, dass Erweiterungsmodule möglichst willkürlicher Anzahl, Typ und Konfiguration am Mikrocontroller anzuschließen sind und automatisch einzurichten sind.

Dieses Modularitätsproblem wird in der Regel auf einem höheren Level als der PCB-Ebene gelöst. Zum Beispiel werden Module angeschlossen, die die Bearbeitung der rohen Signale selbst übernehmen, etwa durch einen eigenen Mikrocontroller, und an das Hauptgerät, insbesondere die elektronische Recheneinrichtung, weiterleiten über eine gemeinsame Schnittstelle, die außerdem oft vorverarbeitet werden bevor diese an den Mikrocontroller weitergeleitet werden.

Andere Lösungen hingegen sind schlicht nicht so flexibel, sondern definieren im Voraus, welche Signale über einen Konnektor geleitet werden, zum Beispiel SPI und I2C. Dadurch wird die Entwicklung von im Voraus nicht antizipierten Erweiterungsmodulen schwieriger, da sie unter Umständen eine Umwandlung in die unterstützten Signale enthalten müssen.

Aufgabe der vorliegenden Erfindung ist es, eine Anordnung sowie ein Verfahren zu schaffen, mittels welchem vereinfacht Eingabe-/Ausgabegeräte an eine elektronische Recheneinrichtung angeschlossen werden können.

Diese Aufgabe wird durch eine Anordnung sowie durch ein Verfahren gemäß den unabhängigen Patentansprüchen gelöst. Vorteilhafte Ausgestaltungsformen sind in den Unteransprüchen angegeben.

Ein Aspekt der Erfindung betrifft eine Anordnung für eine elektronische Recheneinrichtung, mit zumindest einem Mikrocontroller und zumindest einem Eingabe-/Ausgabegerät, welches mit dem Mikrocontroller kommuniziert.

Es ist dabei vorgesehen, dass zwischen dem Mikrocontroller und dem Eingabe-/Ausgabegerät ein integrierter Schaltkreis angeordnet ist, welcher zum Steuern einer Kommunikation zwischen dem Mikrocontroller und dem Eingabe-/Ausgabegerät ausgebildet ist, wobei der integrierte Schaltkreis für eine Erfassung eines Anschluss wenigstens eines Eingabe-/Ausgabegeräts am integrierten Schaltkreis, der Identifikation des Eingabe-/Ausgabegeräts und zum Empfang eines Bitstreams für das jeweilige Eingabe-/Ausgabegerät ausgebildet ist, wobei der integrierte Schaltkreis weiter dazu ausgebildet ist, für den Fall, dass für das jeweilige Eingabe-/Ausgabegerät kein Bitstream empfangen wird, eine Erweiterungsbeschreibung zu erzeugen und auf der Speichereinrichtung zu speichern, wobei der integrierte Schaltkreis für ein partielles Rekonfigurieren einer Partition des integrierten Schaltkreises in Abhängigkeit von dem jeweils empfangenen Bitstream ausgebildet ist.

Die Erweiterungsbeschreibung kann Informationen über die im jeweiligen Eingabe-/Ausgabegerät verwendeten elektronischen Bausteine, insbesondere deren Typbezeichnungen, Seriennummern und/oder Informationen über angewendete technische Standards enthalten.

Die Erweiterungsbeschreibung kann auch Angaben darüber enthalten, welche technische Schnittstelle, insbesondere welches Protokoll mit welchen Parametern implementiert wurde.

Insbesondere wird somit ein integrierter Schaltkreis als modularer Eingabe-/Ausgabe-Coprozessor vorgeschlagen. Insbesondere wird das Eingabe-/Ausgabegerät auch als Input/Output-Gerät bezeichnet.

Insbesondere kann beispielsweise der integrierte Schaltkreis als sogenanntes embedded-Gerät ausgebildet sein. Der integrierte Schaltkreis genauso wie der Mikrocontroller können dabei als Teil der elektronischen Rechnereinrichtung oder auch als separate Teile bereitgestellt werden.

Insbesondere schlägt somit die Erfindung vor, dass der integrierte Schaltkreis als I/O-Coprozessor agiert und den Mikrocontroller von den Erweiterungsmodulen entkoppelt. Das automatische Einrichten kann dabei gelöst werden durch eine Kombination von Identifikationsdaten und partieller Rekonfiguration. Eine partielle Rekonfiguration ist dabei eine Fähigkeit von integrierten Schaltkreisen, bei denen nur Teile, insbesondere sogenannte Partitionen, des integrierten Schaltkreises neu konfiguriert werden und somit neue Hardware-Funktionalität umgesetzt werden kann. Dieses wird hier genutzt, damit Erweiterungsmodule ihre eigene Hardware-Implementierungen beispielsweise mitbringen können.

Insbesondere besteht dabei die Idee darin, dass der Nutzer die Erweiterungsmodule anschließt, die einen sogenannten partiellen Bitstream mitbringen, mit dem eine im Voraus reservierte Partition des integrierten Schaltkreises konfiguriert wird und somit der integrierte Schaltkreis partiell rekonfiguriert wird. Der partielle Bitstream implementiert dabei Hardware-Funktionalität, die das Dekodieren und Enkodieren der rohen Daten- und Kontrollsignale für das Erweiterungsmodul übernimmt. Die eigentliche Kommunikation mit dem Mikrocontroller, die Steuerung der Rekonfiguration und dgl. sind dabei statisch konfigurierte Funktionalitäten und werden von allen Erweiterungsmodulen und im Mikrocontroller geteilt.

Insbesondere ist somit der Hauptunterschied gegenüber dem Stand der Technik der Einsatz des integrierten Schaltkreises zur Erweiterung und Entkopplung der Eingabe-/Ausgabeschnittstellen eines Mikrocontrollers und im Nutzen partieller Rekonfiguration, sodass Expansionsmodule ihre eigene partielle Konfiguration mitbringen.

Dies hat insbesondere den Vorteil, dass Expansionsmodule stark entkoppelt von den Eingabe-/Ausgabeschnittstellen sind, die der Mikrocontroller von Haus aus mitbringt. Dadurch besteht sehr viel mehr Freiraum im Design von Expansionsmodulen, ohne, dass sich die Hardware des Basisgeräts, insbesondere der elektronischen Recheneinrichtung, ändern muss.

Durch den Einsatz des integrierten Schaltkreises kann die Verarbeitung in der Hardware geschehen, was ebenfalls die Freiheit erhöht, da Hardware-Timing-Garantien gegeben werden können, insbesondere erforderlich für die Schnittstellen, die in der Software schlicht nicht möglich sind. Der integrierte Schaltkreis lässt weiterhin zu, dass die Eingangsspannungen vom Pin festgelegt werden, beispielsweise bei 1,8 Volt oder 3,3 Volt.

Die partielle Rekonfiguration sorgt dafür, dass die Daten- und Kontrollsignale auf den Schnittstellenpins dediziert verarbeitet werden können, ohne komplexe und teure Multiplex-/Switch-/oder gar Crossbar Strukturen zum Routen zu benötigen.

Die Expansionsmodule benötigen nicht selbst einen Mikrocontroller oder ähnliches, was deren Komplexität, Größe und Preis senken können. Dennoch sind sie in der Lage, im Voraus nicht antizipierte Funktionalität leicht zu implementieren.

Die Stärken eines integrierten Schaltkreises können hier ausgespielt werden. So kann der integrierte Schaltkreis parallel für andere Aktivitäten verwendet werden. Es können zum Beispiel diverse Hardware-Beschleuniger implementiert werden, beispielsweise zur Datenverarbeitung oder Sicherheit, oder schlicht auch das Agitieren eines Mikrocontroller-Busses übernommen werden. Dies minimiert unter Umständen auch die Anzahl benötigter Integrated-Circuits-Einrichtungen.

Gemäß einer vorteilhaften Ausgestaltungsform ist der integrierte Schaltkreis als eine Field-Programmable-Gate-Array-Einrichtung ausgebildet. Das Field-Programmable-Gate-Array (FPGA) ist eine Art von integriertem Schaltkreis. Im Gegensatz zu herkömmlich integrierten Schaltkreisen kann ein FPGA nach der Herstellung programmiert werden, eine bestimmte Funktion zu erfüllen. Somit kann auf einfache Art und Weise eine Kommunikation zwischen dem Eingabe-/Ausgabegerät und dem Mikrocontroller realisiert werden.

Es hat sich weiterhin als vorteilhaft erwiesen, wenn der integrierte Schaltkreis nach einem Anschluss des zumindest einen Eingabe-/Ausgabegeräts eine partielle Rekonfiguration der eigenen Partition durchführt. Die partielle Rekonfiguration ist dabei wiederum eine Fähigkeit insbesondere des FPGAs, bei denen nur Teile, sogenannte Partitionen des FPGAs, neu konfiguriert werden und somit neue Hardware funktionell umgesetzt wird. Dies wird hier genutzt, damit die Erweiterungsmodule ihre eigene Hardware-Implementierung mitbringen können.

Eine weitere vorteilhafte Ausgestaltungsform sieht vor, dass für den integrierten Schaltkreis ein jeweiliger Bitstream für ein jeweiliges Eingabe-/Ausgabegerät bereitgestellt ist. Somit kann vorgesehen sein, dass die partielle Rekonfiguration auf Basis des Bitstreams bei dem integrierten Schaltkreis durchgeführt werden kann. Somit kann auf einfache Art und Weise die Rekonfiguration des integrierten Schaltkreises realisiert werden.

Weiterhin vorteilhaft ist, wenn das jeweilige Eingabe-/Ausgabegerät mit dem jeweiligen Bitstream bereitgestellt ist. Beispielsweise kann das Eingabe-/Ausgabegerät, welches auch als Erweiterungsmodul bezeichnet werden kann, mit einem entsprechenden ROM-Speicher ausgestattet sein, der sowohl die entsprechenden Identifikationsdaten, das heißt, um welches Modul handelt es sich überhaupt - welche u.a. auch für die Software auf dem Mikrocontroller notwendig sind - als auch den partiellen Bitstream für die partielle Rekonfiguration des integrierten Schaltkreises aufweist - also die zugewiesene Erweiterungspartition. Somit kann beim Anschließen des Eingabe-/Ausgabegeräts die partielle Rekonfiguration auf einfache Art und Weise durchgeführt werden.

Ferner hat es sich vorteilhaft erwiesen, wenn innerhalb einer Speichereinrichtung des integrierten Schaltkreises der jeweilige Bitstream gespeichert ist. Beispielsweise kann auch der integrierte Schaltkreis jeweilige Bitstreams vorhalten und somit bei einem Anschluss eines Eingabe-/Ausgabegeräts den entsprechenden Bitstream aus der Speichereinrichtung auslesen und die partielle Rekonfiguration somit automatisch durchführen.

Weiterhin vorteilhaft ist, wenn in einem Flash-Speicher als Speichereinrichtung der jeweilige Bitstream bereitgestellt ist. Beispielsweise kann der Flash-Speicher in Form eines USB-Sticks oder auch in Form einer SD-Karte vorliegen. So wird es ermöglicht, dass beispielsweise flexibel der Flash-Speicher ausgetauscht werden kann, wodurch auch die entsprechenden Bitstreams aktualisiert werden können. Somit kann zuverlässig der Bitstream für die partielle Rekonfiguration bereitgestellt werden.

Eine weitere vorteilhafte Ausgestaltungsform sieht vor, dass der Bitstream zum Herunterladen aus einem Netzwerk mittels des integrierten Schaltkreises bereitgestellt wird. Beispielsweise kann der integrierte Schaltkreis ein entsprechendes Kommunikationsmodul aufweisen, welches mit einem Netzwerk, beispielsweise dem Internet, kommunizieren kann. Nach dem Identifizieren des Eingabe-/Ausgabegerätes kann dann der Bitstream aus dem Netzwerk heruntergeladen werden. Ferner ist es auch möglich, dass beispielsweise die elektronische Recheneinrichtung mit dem Netzwerk verbunden ist und der integrierte Schaltkreis über den Mikrocontroller den entsprechenden Bitstream herunterladen kann. Somit kann zuverlässig der Bitstream für die partielle Rekonfiguration bereitgestellt werden.

Eine weitere vorteilhafte Ausgestaltungsform sieht vor, dass der integrierte Schaltkreis zum Umwandeln von Rohdaten des Eingabe-/Ausgabegerätes für den Mikrocontroller ausgebildet ist. Insbesondere ist somit vorgesehen, dass beispielsweise der integrierte Schaltkreis für den Mikrocontroller die entsprechenden Daten umwandelt, sodass der Mikrocontroller bereits vorverarbeitete Daten erhält und somit nicht die Rohdaten entsprechend umwandeln muss. Somit kann der Mikrocontroller mit einer entsprechenden geringeren Rechenkapazität ausgestattet sein.

Ferner hat es sich als vorteilhaft erwiesen, wenn der integrierte Schaltkreis eine Pinanordnung aufweist, welche mit allen Konnektoren des integrierten Schaltkreises verbunden ist. Insbesondere weist somit der integrierte Schaltkreis eine externe Schnittstelle für die partielle Rekonfiguration auf, beispielsweise je nach Hersteller als JTAG, ISAP oder andere. Diese enthält zusätzliche Steuersignale für das Laden der partiellen Bitstreams von den entsprechenden Erweiterungsmodulen. Entsprechend werden die Pins dieser Schnittstelle mit allen Konnektoren verbunden.

Es hat sich weiter als vorteilhaft erwiesen, wenn der integrierte Schaltkreis zumindest eine weitere Pinanordnung aufweist, wobei die weitere Pinanordnung zum Verbinden mit dem zumindest einem Eingabe-/Ausgabegerät ausgebildet ist. Insbesondere ist somit eine Erweiterungsschnittstelle am integrierten Schaltkreis vorgesehen, die jeweils ein Erweiterungsmodul und eine gewisse Anzahl an Pins bereitstellt und mit dem entsprechenden externen Konnektor verbunden ist. Die Bedeutung der Pins ist dabei spezifisch für jedes Erweiterungsmodul. Um diese zu de- und enkodieren, werden auf dem integrierten Schaltkreis entsprechend viele Erweiterungspartitionen reserviert, die mit dem speziellen Hardwaremodul dynamisch rekonfiguriert werden können, die die Signale der angeschlossenen Erweiterungsmodule in ein gemeinsames Format umwandeln.

Weiter vorteilhaft ist, wenn ein integrierter Schaltkreis zumindest zwei weitere Pinanordnungen aufweist, wobei die zwei weiteren Pinanordnungen homogen ausgebildet sind. Insbesondere sind somit die Pinanordnungen für die entsprechenden Erweiterungsmodule/Eingabe-/Ausgabegeräte homogen ausgebildet, sodass zuverlässig eine Vielzahl von unterschiedlichen Eingabe-/Ausgabegeräten angeschlossen werden kann.

Ein weiterer Aspekt der Erfindung betrifft ein Verfahren zum Betreiben einer Anordnung nach dem vorhergehenden Aspekt. Insbesondere Rohdaten von dem Eingabe-/Ausgabegerät werden mittels des integrierten Schaltkreises in für den Mikrocontroller lesbare Daten umgewandelt, wobei
ein Neuanschluss eines Eingabe-/Ausgabegeräts an den integrierten Schaltkreis mittels des integrierten Schaltkreises dem Mikrocontroller mitgeteilt wird.

Gemäß einer vorteilhaften Ausgestaltungsform des Verfahrens wird wenigstens eine auf der Speichereinrichtung gespeicherte Erweiterungsbeschreibung durch ein externes System ausgelesen und mittels der Erweiterungsbeschreibung jeweils eine neue Firmware und/oder Bitstream für den integrierten Schaltkreis kompiliert und dann auf den integrierten Schaltkreis übertragen.

Dadurch kann vorteilhafterweise der rechenintensive Prozess einer Code-Kompilierung auf das externe System ausgelagert werden und der integrierte Schaltkreis kann damit ein kostengünstigerer Typ mit geringerer Rechenleistung und kleinerer Bauform sein.

Bei dem vorgestellten Verfahren handelt es sich insbesondere um ein computerimplementiertes Verfahren. Da betrifft ein weiterer Aspekt der Erfindung auch ein Computerprogrammprodukt mit Programmcodemitteln, welche eine elektronische Recheneinrichtung und/oder den integrierten Schaltkreis zu veranlassen, wenn die Programmcodemittel von der elektronischen Recheneinrichtung und/oder dem integrierten Schaltkreis abgearbeitet werden, ein Verfahren nach dem vorhergehenden Aspekt durchzuführen. Ferner betrifft die Erfindung daher auch ein computerlesbares Speichermedium mit dem Computerprogrammprodukt.

Vorteilhafte Ausgestaltungsformen der Anordnung sind ferner als vorteilhafte Ausgestaltungsformen des Verfahrens anzusehen.

Die Anordnung weist hierzu gegenständliche Merkmale auf, um den entsprechenden Verfahrensschritt durchführen zu können.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren gezeigten Merkmale und Merkmalskombinationen können nicht nur in der jeweils angegebenen Kombination, sondern auch in anderen Kombinationen von der Erfindung umfasst sein. Es können insbesondere auch Ausführungen und Merkmalskombinationen von der Erfindung umfasst sein, die nicht alle Merkmale eines ursprünglich formulierten Anspruchs aufweisen. Es können darüber hinaus Ausführungen und Merkmalskombinationen von der Erfindung umfasst, die über die in den Rückbezügen der Ansprüche dargelegten Merkmalskombinationen hinausgehen oder von diesen abweichen.

Dabei zeigt:
FIG eine schematische Blockschaltbild gemäß einer Ausführungsform einer Anordnung;

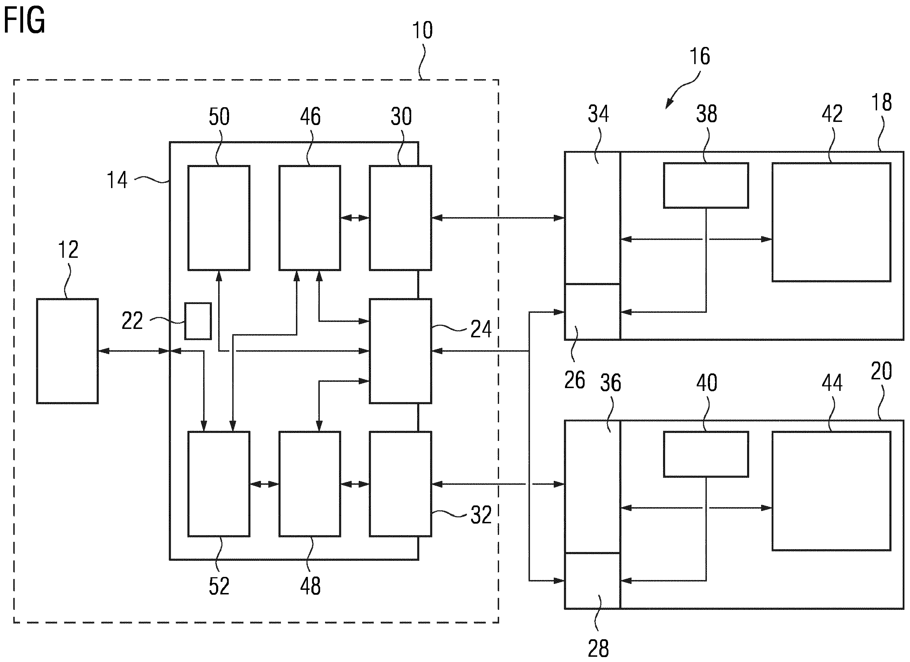

Die Erfindung wird im Folgenden anhand konkreter Ausführungsbeispiele und zugehöriger schematischer Zeichnungen näher erläutert. In der Figur können gleiche oder funktionsgleiche Elemente mit denselben Bezugszeichen versehen sein.

Die FIG zeigt ein schematisches Blockschaltbild gemäß einer Ausführungsform einer elektronischen Recheneinrichtung 10. Die elektronische Recheneinrichtung 10 weist im vorliegenden Ausführungsbeispiel zumindest einen Mikrocontroller 12 sowie einen integrierten Schaltkreis 14, insbesondere in Form eines FPGAs (Field-Programmable-Gate-Array), auf.

Insbesondere zeigt die FIG insgesamt eine Anordnung 16 für die elektronische Recheneinrichtung 10, mit zumindest dem Mikrocontroller 12 und zumindest einem Eingabe-/Ausgabegerät 18, 20, welches mit dem Mikrocontroller 12 kommuniziert. Es ist dabei vorgesehen, dass zwischen dem Mikrocontroller 12 und dem Eingabe-/Ausgabegerät 18, 20 der integrierte Schaltkreis 14 angeordnet ist, welcher zum Steuern der Kommunikation zwischen dem Mikrocontroller 12 und dem Eingabe-/Ausgabegerät 18, 20 ausgebildet ist.

Die FIG zeigt ferner, dass beispielsweise der integrierte Schaltkreis 14 eine Speichereinrichtung 22 aufweisen kann, welche zum Speichern eines Bitstreams ausgebildet ist. Die Speichereinrichtung 22 kann dabei insbesondere in Form eines Flash-Speichers ausgebildet sein, beispielsweise in Form einer SD-Karte.

Ferner zeigt die FIG, dass der integrierte Schaltkreis 14 eine Pinanordnung 24 aufweist, wobei die Pinanordnung 24 mit allen Konnektoren des integrierten Schaltkreises 14 verbunden ist. Ferner ist die Pinanordnung 24 vorliegend mit einem sogenannten Konfigurationsmodul 26, 28 des jeweiligen Eingabe-/Ausgabegeräts 18, 20 gekoppelt. Ferner zeigt die FIG, dass der integrierte Schaltkreis 14, zumindest eine weitere Pinanordnungen 30, 32, vorliegend, insbesondere zwei weitere Pinanordnungen 30, 32 aufweist, wobei die weiteren Pinanordnungen 30, 32 zum Verbinden mit dem zumindest einem Eingabe-/Ausgabegerät 18, 20 ausgebildet sind. Beispielsweise kann eine erste weitere Pinanordnung 30 mit einem ersten Verbindungsmodul 34 eines ersten Eingabe-/Ausgabegerätes 18 gekoppelt sein und die zweite weitere Pinanordnung 32 kann mit einem zweiten Verbindungsmodul 36 eines zweiten Eingabe-/Ausgabegeräts 20 gekoppelt sein.

Im vorliegenden Ausführungsbeispiel kann vorgesehen sein, dass der integrierte Schaltkreis 14, insbesondere die zwei weiteren Pinanordnungen 30, 32 aufweist, wobei die zwei weiteren Pinanordnungen 30, 32 homogen ausgebildet sind.

Ferner zeigt die FIG, dass beispielsweise das erste Eingabe-/Ausgabegerät 18 einen ersten ROM-Speicher 38 aufweisen kann und das zweite Eingabe-/Ausgabegerät 20 einen zweiten ROM-Speicher 40 aufweisen kann. Des Weiteren weist das erste Eingabe-/Ausgabegerät 18 einen ersten spezifischen Schaltkreis 42 auf und das zweite Eingabe-/Ausgabegerät 20 weist einen zweiten spezifischen Schaltkreis 44 auf.

Ferner ist gezeigt, dass der integrierte Schaltkreis 14 beispielsweise für die erste weitere Pinanordnung 30 eine erste Erweiterungspartition 46 aufweist und für die zweite weitere Pinanordnung 32 eine zweite Erweiterungspartition 48 aufweist.

Ferner weist der integrierte Schaltkreis 14 einen sogenannten Erweiterungshändler und partiellen Rekonfigurator auf, welcher vorliegend das Bezugszeichen 50 hat. Ferner weist der integrierte Schaltkreis 14 eine Mikrocontroller-Schnittstelle 52 auf, welche zum Kommunizieren mit dem Mikrocontroller 12 ausgebildet ist.

Weiterhin kann vorgesehen sein, dass der integrierte Schaltkreis 14 nach einem Anschluss des zumindest einen Eingabe-/Ausgabegerätes 18, 20 eine partielle Rekonfiguration der seiner eigenen Partition durchführt. Ferner kann vorgesehen sein, dass für den integrierten Schaltkreis 14 ein jeweiliger Bitstream für ein jeweiliges Eingabe-/Ausgabegerät 18, 20 bereitgestellt wird. Dabei kann vorgesehen sein, dass das jeweilige Eingabe-/Ausgabegerät 18, 20 mit dem jeweiligen Bitstream bereitgestellt ist. Alternativ oder ergänzend kann innerhalb der Speichereinrichtung 22 des integrierten Schaltkreises 14 der jeweilige Bitstream gespeichert sein. Nochmals alternativ oder ergänzend kann der Bitstream zum Herunterladen aus einem Netzwerk mittels des integrierten Schaltkreises 14 bereitgestellt werden.

Insbesondere kann vorgesehen sein, dass der integrierte Schaltkreis 14 zum Umwandeln von Rohdaten des Eingabe-/Ausgabegerätes 18, 20 für den Mikrocontroller 12 ausgebildet ist.

Insbesondere zeigt somit die FIG, dass durch den Einsatz des integrierten Schaltkreises 14, insbesondere des FPGAs, der Mikrocontroller 12 von den Eingabe-/Ausgabegeräten 18, 20 entkoppelt ist. Das automatische Einrichten ist dadurch gelöst, dass eine Kombination von Identifikationsdaten und partieller Rekonfiguration mittels integrierten Schaltkreises 14 durchgeführt wird. Eine partielle Rekonfiguration ist dabei die Fähigkeit eines FPGAs, bei denen nur Teile, insbesondere sogenannte Partitionen, des FPGAs neu konfiguriert werden und somit neue Hardware-Funktionalität umgesetzt werden kann. Dies wird genutzt, damit die entsprechenden Erweiterungsmodule, also die Eingabe-/Ausgabegeräte 18, 20 ihre eigene Hardware-Implementierung mitbringen können.

Die Idee ist somit, dass ein Nutzer die Eingabe-/Ausgabegeräte 18, 20 anschließt, die einen sogenannten partiellen Bitstream mitbringen, mit dem eine im Voraus reservierte Partition am FPGA konfiguriert wird und somit das FPGA partiell rekonfiguriert wird. Der partielle Bitstream implementiert dabei Hardware-Funktionalität, die das Dekodieren und Enkodieren der rohen Daten- und Kontrollsignale für das Eingabe-/Ausgabegerät 18, 20 übernimmt. Die eigentliche Kommunikation mit dem Mikrocontroller 12, die Steuerung der Rekonfiguration und dgl. sind dabei statisch konfigurierte Funktionalitäten und werden von allen Eingabe-/Ausgabegeräten 18, 20 und dem Mikrocontroller 12 geteilt.

Die FIG illustriert dabei ein konkretes Beispiel. Dabei zeigt die FIG insbesondere die relevanten Schnittstellen und Komponenten. Auf dem FPGA wird die Pinanordnung 24 für die partielle Rekonfiguration festgelegt, je nach Hersteller und konkretem FPGA-Model, beispielsweise über JTag oder ISAP oder andere. Diese enthält zusätzliche Steuersignale für das Laden der partiellen Bitstreams von den Eingabe-/Ausgabegeräten 18, 20. Entsprechend werden die Pins dieser Schnittstelle mit allen Konnektoren/weiteren Pinaornungen 30, 32 verbunden.

Daneben gibt es mehrere homogene externe Erweiterungsschnittstellen, insbesondere die weiteren Pinanordnungen 30, 32, die jeweils einem Eingabe-/Ausgabegerät 18, 20 eine gewisse Anzahl an Pins bereitstellen und mit dem entsprechenden externen Konnektor verbunden sind. Die Bedeutung der Pins ist spezifisch für jedes Erweiterungsmodul/Eingabe-/Ausgabegerät 18,20. Um diese zu de- und enkodieren, werden auf dem FPGA entsprechend viele Erweiterungspartitionen reserviert, die mit speziellen Hardware-Modulen die dynamisch rekonfiguriert werden können, die die Signale der angeschlossenen Eingabe-/Ausgabegeräte 18, 20 in ein gemeinsames Format umwandeln.

In dem vorgestellten konkreten Beispiel sind die Eingabe-/Ausgabegeräte 18, 20 mit dem ROM-Speicher 38, 40 ausgestattet, das sowohl Identifikationsdaten, das heißt um welches Modul handelt es sich überhaupt, als auch den partiellen Bitstream für die partielle Rekonfiguration des FPGAs, also der zugewiesenen Erweiterungspartition, enthält.

Dabei werden folgende Schritte zum Booten der Gateways oder beim Einstecken eines Eingabe-/Ausgabegeräts 18, 20 abgehandelt. Alle Eingabe-/Ausgabegeräte 18, 20 werden durchgelaufen, das heißt die folgenden Schritte werden für alle Konnektoren wiederholt. Die Identifikation des Eingabe-/Ausgabegeräts 18, 20 wird geprüft und u.a. an den Mikrocontroller 12 weitergeleitet, damit dieser etwaige Treiber oder ähnliches laden kann. Analog zum partiellen Bitstream könnte das ROM auch die Software-Treiber enthalten. Der sogenannte Extension-Handler lädt den partiellen Bitstream, der im ROM-Speicher 38, 40 der Eingabe-/Ausgabegeräte 18, 20 gespeichert ist, in die für die entsprechenden Schnittstellen reservierten Erweiterungspartition. Dieser kümmert sich darum, dass die neu konfigurierten Funktionen genutzt werden können. Dem Eingabe-/Ausgabegerät 18, 20 und dem Mikrocontroller 12 wird mitgeteilt, dass die Erweiterung nun eingerichtet ist.

Ferner sind auch andere Realisierungen möglich. Etwa könnten die partiellen Bitstreams aller bekannten Eingabe-/Ausgabegeräte 18, 20 auf der SD-Karte gespeichert sein und das FPGA holt sich die notwendigen Informationen anhand der Identifikationsdaten der tatsächlich angeschlossenen Eingabe-/Ausgabegeräte 18, 20. Diese Lösung zum Beispiel ist zwar weniger flexibel, dafür aber günstiger. Insgesamt lassen sich durch geschickte Aufteilung der einzelnen Komponenten eine Vielzahl solcher Trade-Offs erzielen.

### Bezugszeichenliste

- 10: Elektronische Recheneinrichtung
- 12: Mikrocontroller
- 14: integrierter Schaltkreis
- 16: Anordnung
- 18: erstes Eingabe-/Ausgabegerät
- 20: zweites Eingabe-/Ausgabegerät
- 22: Speichereinrichtung
- 24: Pinanordnung
- 26: erstes Konfigurationsmodul
- 28: zweites Konfigurationsmodul
- 30: erste weitere Pinanordnung
- 32: zweite weitere Pinanordnung
- 34: erstes Verbindungsmodul
- 36: zweites Verbindungsmodul
- 38: erster ROM-Speicher
- 40: zweiter ROM-Speicher
- 42: erster spezifischer Schaltkreis
- 44: zweiter spezifischer Schaltkreis
- 46: erste Erweiterungspartition
- 48: zweite Erweiterungspartition
- 50: Extension-Handler und partieller Rekonfigurator
- 52: Mikrocontroller-Schnittstelle

## Patentansprüche

1. Anordnung (16) für eine elektronische Recheneinrichtung (10), mit zumindest einem Mikrocontroller (12) und zumindest einem Eingabe-/Ausgabegerät (18, 20), welches mit dem Mikrokontroller (12) kommuniziert,
**dadurch gekennzeichnet, dass**
zwischen dem Mikrocontroller (12) und dem Eingabe-/Ausgabegerät (18, 20) ein integrierter Schaltkreis (14) angeordnet ist, welcher zum Steuern einer Kommunikation zwischen dem Mikrocontroller (12) und dem Eingabe-/Ausgabegerät (18, 20) ausgebildet ist, wobei der integrierte Schaltkreis (14) für eine Erfassung eines Anschluss wenigstens eines Eingabe-/Ausgabegeräts (18, 20) am integrierten Schaltkreis (14), der Identifikation des Eingabe-/Ausgabegeräts (18, 20) und zum Empfang eines Bitstreams für das jeweilige Eingabe-/Ausgabegerät (18, 20) ausgebildet ist, wobei der integrierte Schaltkreis (14) weiter dazu ausgebildet ist, für den Fall, dass für das jeweilige Eingabe-/Ausgabegerät (18, 20) kein Bitstream empfangen wird, eine Erweiterungsbeschreibung zu erzeugen und auf der Speichereinrichtung (22) zu speichern, wobei der integrierte Schaltkreis (14) für ein partielles Rekonfigurieren einer Partition des integrierten Schaltkreises (14) in Abhängigkeit von dem jeweils empfangenen Bitstream ausgebildet ist.

2. Anordnung (16) nach Anspruch 1, **dadurch gekennzeichnet, dass**
der integrierte Schaltkreis (14) als eine Field-Programmable-Gate-Array-Einrichtung ausgebildet ist.

3. Anordnung (16) nach Anspruch 1 oder 2, **dadurch gekennzeichnet, dass**
der integrierte Schaltkreis (14) nach einem Anschluss des zumindest einen Eingabe-/Ausgabegeräts (18, 20) eine partielle Rekonfiguration der eigenen Partition durchführt.

4. Anordnung (16) nach einem der vorhergehenden Ansprüche, **dadurch gekennzeichnet, dass** für den integrierten Schaltkreis (14) ein jeweiliger Bitstream für ein jeweiliges Eingabe-/Ausgabegerät (18, 20) bereitgestellt ist.

5. Anordnung (16) nach Anspruch 4, **dadurch gekennzeichnet, dass**
das jeweilige Eingabe-/Ausgabegerät (18, 20) mit dem jeweiligen Bitstream bereitgestellt ist.

6. Anordnung (16) nach einem der Ansprüche 4 oder 5, **dadurch gekennzeichnet, dass** innerhalb einer Speichereinrichtung (22) des integrierten Schaltkreises (14) der jeweilige Bitstream gespeichert ist.

7. Anordnung (16) nach Anspruch 6, **dadurch gekennzeichnet, dass**
in einem Flash-Speicher als Speichereinrichtung (22) der jeweilige Bitstream bereitgestellt ist.

8. Anordnung (16) nach einem der Ansprüche 4 bis 7, **dadurch gekennzeichnet, dass**
der Bitstream zum Herunterladen aus einem Netzwerk mittels des integrierten Schaltkreises (14) bereitgestellt wird.

9. Anordnung (16) nach einem der vorhergehenden Ansprüche, **dadurch gekennzeichnet, dass** der integrierte Schaltkreis (16) zum Umwandeln von Rohdaten des Eingabe-/Ausgabegeräts (18, 20) für den Mikrocontroller (12) ausgebildet ist.

10. Anordnung (16) nach einem der vorhergehenden Ansprüche, **dadurch gekennzeichnet, dass**
der integrierte Schaltkreis (14) eine Pinanordnung (24) aufweist, welche mit allen Konnektoren des integrierten Schaltkreises (14) verbunden ist.

11. Anordnung (16) nach einem der vorhergehenden Ansprüche, **dadurch gekennzeichnet, dass**
der integrierte Schaltkreis (14) zumindest eine weitere Pinanordnung (30, 32) aufweist, wobei die weitere Pinanordnung (30, 32) zum Verbinden mit dem zumindest einem Eingabe-/Ausgabegerät (18, 20) ausgebildet ist.

12. Anordnung (16) nach Anspruch 11, **dadurch gekennzeichnet, dass**
der integrierte Schaltkreis (14) zumindest zwei weitere Pinanordnungen (30, 32) aufweist, wobei die zwei weiteren Pinanordnungen (30, 32) homogen ausgebildet sind.

13. Verfahren zum Betreiben einer Anordnung (16) nach einem der Ansprüche 1 bis 12,
**dadurch gekennzeichnet, dass**
Rohdaten von dem Eingabe-/Ausgabegerät (18, 20) mittels des integrierten Schaltkreises (14) in für den Mikrocontroller (12) lesbare Daten umgewandelt werden, wobei
ein Neuanschluss eines Eingabe-/Ausgabegeräts (18, 20) an den integrierten Schaltkreis (14) mittels des integrierten Schaltkreises (14) dem Mikrocontroller (12) mitgeteilt wird.

14. Verfahren nach Anspruch 13, **dadurch gekennzeichnet, dass** wenigstens eine auf der Speichereinrichtung (22) gespeicherte Erweiterungsbeschreibung durch ein externes System ausgelesen wird und mittels der Erweiterungsbeschreibung jeweils eine neue Firmware und/oder Bitstream für den integrierten Schaltkreis (14) kompiliert und dann auf den integrierten Schaltkreis (14) übertragen wird.
